# EUROPÄISCHE PATENTSCHRIFT

(11) **EP 2 519 980 B1**
(45) Veröffentlichungstag und Bekanntmachung des Hinweises auf die Patenterteilung: **03.04.2019**
(21) Anmeldenummer: 10798567.3
(22) Anmeldetag: 27.12.2010
(51) Int. Cl.: H01L 33/04, H01L 33/14, H01L 33/06, H01L 33/38

(54) **LICHTEMITTIERENDER HALBLEITERCHIP**
LIGHT-EMITTING SEMICONDUCTOR CHIP
PUCE À SEMI-CONDUCTEURS ÉLECTROLUMINESCENTE

(30) Priorität: 30.12.2009 DE 102009060747
(43) Veröffentlichungstag der Anmeldung: 07.11.2012
(73) Patentinhaber: OSRAM Opto Semiconductors GmbH, 93055 Regensburg (DE)
(72) Erfinder: PETER, Matthias, 93087 Alteglofsheim (DE); MEYER, Tobias, 93346 Ihrlerstein (DE); WALTER, Alexander, 93164 Laaber (DE); TAKI, Tetsuya, Yokohama 223-0057 (JP); OFF, Jürgen, 93059 Regensburg (DE); BUTENDEICH, Rainer, 93059 Regensburg (DE); HERTKORN, Joachim, 93087 Alteglofsheim (DE)
(74) Vertreter: Epping - Hermann - Fischer
(86) Internationale Anmeldenummer: PCT/EP2010/070761
(87) Internationale Veröffentlichungsnummer: WO 2011/080249

(56) Entgegenhaltungen:
- EP-A2- 2 523 228
- WO-A2-2009/045005
- WO-A2-2009/072787
- US-A1- 2006 081 861
- US-A1- 2008 149 918
- US-B1- 6 677 619

## Beschreibung

Die vorliegende Anmeldung betrifft einen Halbleiterchip, der zur Erzeugung von Strahlung vorgesehen ist.

LED-Halbleiterchips weisen oftmals einen zur Strahlungserzeugung vorgesehenen aktiven Bereich mit mehreren Quantentöpfen (quantum wells) auf.

Bei InGaN-Quantentöpfen im aktiven Bereich hat sich gezeigt, dass die abgestrahlte Strahlungsleistung nicht mit zunehmender Stromdichte linear ansteigt. Eine Ursache hierfür ist, dass die Ladungsträger oftmals nicht effizient in die Quantentöpfe injiziert werden.

Eine Aufgabe ist es, einen Halbleiterchip anzugeben, bei dem Ladungsträger effizient in den aktiven Bereich injiziert werden können.

Diese Aufgabe wird durch den Gegenstand des unabhängigen Patentanspruchs 1 gelöst. Weitere Ausgestaltungen und Weiterbildungen sind Gegenstand der abhängigen Patentansprüche.

In einer Ausführungsform weist ein Halbleiterchip einen Halbleiterkörper mit einer Halbleiterschichtenfolge auf, wobei die Halbleiterschichtenfolge eine n-leitende Mehrschichtstruktur, eine p-leitende Halbleiterschicht und einen zur Erzeugung von Strahlung vorgesehenen aktiven Bereich aufweist. Der aktive Bereich ist zwischen der n-leitenden Mehrschichtstruktur und der p-leitenden Halbleiterschicht angeordnet. In der n-leitenden Mehrschichtstruktur ist ein Dotierprofil ausgebildet, das zumindest eine Dotierspitze aufweist.

Das Dotierprofil stellt insbesondere einen Verlauf der Dotierung in vertikaler Richtung, also in einer Richtung, die entlang einer Abscheiderichtung für die Halbleiterschichtenfolge des Halbleiterkörpers verläuft, dar. Mit anderen Worten verläuft das Dotierprofil senkrecht zu einer Haupterstreckungsebene der Halbleiterschichten der Halbleiterschichtenfolge des Halbleiterkörpers.

Unter einer Dotierspitze wird im Rahmen der Anmeldung ein Bereich eines Halbleitermaterials verstanden, der verglichen mit zumindest einem daran angrenzenden Bereich eine hohe Dotierkonzentration aufweist. Das die Dotierspitze, vorzugsweise auf beiden Seiten, umgebende Halbleitermaterial ist vorzugsweise niedrig dotiert, undotiert oder intrinsisch ausgebildet.

Unter einer hohen Dotierkonzentration wird insbesondere eine Konzentration von mindestens 2 * 10¹⁸ cm⁻³ verstanden.

Unter einer niedrigen Dotierkonzentration wird insbesondere eine Konzentration von mindestens 1 * 10¹⁶ cm⁻³ und höchstens 1 * 10¹⁸ cm⁻³ verstanden.

Es hat sich gezeigt, dass eine, insbesondere im Vergleich zur restlichen Ausdehnung der n-leitenden Mehrschichtstruktur dünne und hochdotierte, Dotierspitze zu einer verbesserten Ladungsträgerinjektion in den aktiven Bereich des Halbleiterchips führt. Aufgrund der hohen Dotierung weist die n-leitende Mehrschichtstruktur im Bereich der Dotierspitze eine vergleichsweise hohe Querleitfähigkeit, also eine hohe Leitfähigkeit in lateraler Richtung, auf, so dass Ladungsträger in lateraler besonders homogen in den aktiven Bereich injiziert werden können. Auch in Rückwärtsrichtung, also in Sperr-Richtung des aktiven Bereichs führt die zumindest eine Dotierspitze zu einem lateral homogeneren Stromfluss. Dadurch weisen die Halbleiterchips eine verringerte Empfindlichkeit gegenüber elektrostatischer Entladung (electrostatic discharge, ESD) auf.

In einer bevorzugten Ausgestaltung weist die n-leitende Mehrschichtstruktur zumindest einen mittels der Dotierspitze hochdotierten Bereich und einen niedrig n-leitend dotierten Bereich auf. Vorzugsweise ist eine Dotierkonzentration in der zumindest einen Dotierspitze mindestens fünffach, besonders bevorzugt mindestens achtfach, beispielsweise zehnfach, so hoch wie in dem niedrig n-leitend dotierten Bereich der n-leitenden Mehrschichtstruktur.

Der niedrig n-leitend dotierte Bereich kann hierbei insbesondere an die Dotierspitze angrenzen.

Vorzugsweise beträgt die Dotierkonzentration in der Dotierspitze mindestens 4 * 10¹⁸ cm⁻³. Durch eine hohe Dotierkonzentration kann eine hohe Leitfähigkeit erzielt werden.

Weiterhin bevorzugt beträgt die Dotierkonzentration in der Dotierspitze höchstens 1 * 10²⁰ cm⁻³, besonders bevorzugt höchstens 3 * 10¹⁹ cm⁻³.

Weiterhin bevorzugt beträgt die Dotierkonzentration in dem, insbesondere angrenzenden, niedrig n-leitend dotierten Bereich höchstens 5 * 10¹⁷ cm⁻³, besonders bevorzugt höchstens 2 * 10¹⁷ cm⁻³.

In einer bevorzugten Ausgestaltung beträgt eine Dotierkonzentration in der zumindest einen Dotierspitze mindestens 4 * 10¹⁸ cm⁻³ und in dem niedrig n-leitend dotierten Bereich höchstens 8 * 10¹⁷ cm⁻³.

Eine vertikale Ausdehnung der Dotierspitze beträgt vorzugsweise zwischen einschließlich 1 nm und einschließlich 30 nm, besonders bevorzugt zwischen einschließlich 2 nm und einschließlich 20 nm. Insbesondere kann die vertikale Ausdehnung der Dotierspitze zwischen einschließlich 7 nm und einschließlich 10 nm betragen.

Die n-leitende Mehrschichtstruktur dient im Betrieb des Halbleiterchips insbesondere der Injektion von Elektronen in den aktiven Bereich. Hierfür muss die n-leitende Mehrschichtstruktur nicht notwendigerweise durchgängig n-leitend dotiert sein. Vielmehr kann die n-leitende Mehrschichtstruktur auch eine oder mehrere Schichten aufweisen, in denen die n-leitende Mehrschichtstruktur undotiert oder intrinsisch ausgeführt ist.

Entsprechend ist die p-leitende Halbleiterschicht insbesondere für die Injektion von Löchern in den aktiven Bereich vorgesehen. Die p-leitende Halbleiterschicht kann auch mehrschichtig ausgebildet sein, wobei sich einzelne Schichten in der Dotierung und/oder der

Kristallzusammensetzung unterscheiden können.

Der Halbleiterkörper basiert vorzugsweise auf einem Verbindungshalbleiter, insbesondere auf einem Nitrid-Verbindungshalbleiter.

"Auf Nitrid-Verbindungshalbleitern basierend" bedeutet im vorliegenden Zusammenhang, dass die aktive EpitaxieSchichtenfolge oder zumindest eine Schicht davon ein Nitrid-III/V-Verbindungshalbleitermaterial, vorzugsweise Al_{y}Ga_{1-x-y}InₓN umfasst, wobei 0 ≤ x ≤ 1, 0 ≤ y ≤ 1 und x + y ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des Al_{y}Ga_{1-x-y}InₓN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Der aktive Bereich weist vorzugsweise eine Mehrzahl von Quantenschichten auf. Die Quantenschichten sind zweckmäßigerweise zwischen Barriereschichten angeordnet. Die Quantenschichten und Barriereschichten können hierbei eine Quantenstruktur bilden.

Die Bezeichnung Quantenstruktur umfasst im Rahmen der Anmeldung insbesondere jegliche Struktur, bei der Ladungsträger durch Einschluss ("confinement") eine Quantisierung ihrer Energiezustände erfahren können. Insbesondere beinhaltet die Bezeichnung Quantenstruktur keine Angabe über die Dimensionalität der Quantisierung. Sie umfasst somit unter anderem Quantentröge, Quantendrähte und Quantenpunkte und jede Kombination dieser Strukturen.

In einer bevorzugten Ausgestaltung weist die n-leitende Mehrschichtstruktur eine Quantenstruktur auf. Diese Quantenstruktur kann eine Mehrzahl von Quantenschichten aufweisen.

Unter dem Begriff Quantenstruktur wird weiterhin insbesondere sowohl eine Ausgestaltung als Mehrfachquantentopfstruktur (multi quantum well, MQW) als auch eine Ausgestaltung als Übergitter verstanden. Im Unterschied zu einer Mehrfachtopfquantenstruktur sind bei einem Übergitter die Abstände benachbarter Quantenschichten so gering, dass Elektronenzustände benachbarter Quantenschichten miteinander quantenmechanisch koppeln und gemeinsame Elektronenzustände ausbilden.

Beispielsweise können zwischen den Quantenschichten eines Übergitters Barriereschichten ausgebildet sein, die eine Dicke von 5 nm oder weniger, beispielsweise 2 nm, aufweisen.

In einer bevorzugten Ausgestaltung ist eine Bandlücke der Quantenschicht der n-leitenden Mehrschichtstruktur mindestens so groß wie eine Bandlücke der Quantenschicht des aktiven Bereichs. Besonders bevorzugt ist die Bandlücke der Quantenschicht größer als die Bandlücke der Quantenschicht des aktiven Bereichs. Beispielsweise können bei einem Halbleiterchip auf der Basis eines Nitrid-Verbindungshalbleiters die Quantenschichten der n-leitenden Mehrschichtstruktur einen geringeren Indium-Gehalt x aufweisen als die Quantenschichten des aktiven Bereichs.

Die Quantenschichten der n-leitenden Mehrschichtstruktur sind im Unterschied zu den Quantenschichten des aktiven Bereichs nicht zur Erzeugung von Strahlung vorgesehen, sondern dienen insbesondere einer effizienten Injektion von Elektronen in den aktiven Bereich, in dem diese unter Emission von Strahlung mit Löchern rekombinieren könne.

Die Quantenschichten des aktiven Bereichs sind vorzugsweise intrinsisch oder undotiert ausgeführt.

In einer weiteren bevorzugten Ausgestaltung ist die Dotierspitze zwischen der dem aktiven Bereich nächstgelegenen Quantenschicht der n-leitenden Mehrschichtstruktur und dem der n-leitenden Mehrschichtstruktur nächstgelegenen Quantenschicht des aktiven Bereichs angeordnet. Eine gute laterale Stromverteilung in der Nähe des aktiven Bereichs ist so gewährleistet.

Weiterhin bevorzugt beträgt ein Abstand der Dotierspitze vom aktiven Bereich, insbesondere von dem der n-leitenden Mehrschichtstruktur nächstgelegenen Quantenschicht des aktiven Bereichs, einen Abstand zwischen einschließlich 1 nm und 30 nm, besonders bevorzugt zwischen einschließlich 2 nm und einschließlich 20 nm, insbesondere zwischen einschließlich 7 nm und einschließlich 10 nm.

Mittels dieser hochdotierten Dotierspitze in der Nähe des aktiven Bereichs kann eine Injektion von Ladungsträgern in den aktiven Bereich besonders effizient und insbesondere in lateraler Richtung besonders homogen erfolgen. Auch in Sperr-Richtung bewirkt die zumindest eine Dotierspitze aufgrund der hohen Querleitfähigkeit eine verbesserte Nutzung vieler möglicher Ladungsträgerpfade, was die Gefahr einer ESD-Schädigung verglichen mit einem Halbleiterchip, der keine Dotierspitzen im n-leitenden Bereich des Halbleiterkörpers aufweist, vermindert.

Die zumindest eine Dotierspitze ist vorzugsweise derart ausgebildet, dass das Dotierprofil scharfe Übergänge von einer niedrigen Dotierkonzentration zu einer hohen Dotierkonzentration und umgekehrt aufweist. Bei der Herstellung des Halbleiterchips kann dies durch eine geringe Wachstumsrate, etwa durch eine Rate zwischen 20 nm/h und 500 nm/h erzielt werden. Vorzugsweise erfolgt die Abscheidung epitaktisch, etwa mittels MOCVD.

In einer bevorzugten Weiterbildung weist eine Kristallstruktur der n-leitenden Mehrschichtstruktur V-förmige Gruben auf. Derartige Gruben, die sich bei der Abscheidung der Halbleiterschichten insbesondere entlang von Versetzungslinien ausbilden können, werden auch als "V-pits" bezeichnet. Solche V-förmigen Gruben können sich insbesondere bei einer vergleichsweisen niedrigen Abscheidetemperatur des Halbleitermaterials, etwa unterhalb von 950° C, ausbilden. Diese V-förmigen Gruben können zu einem verbesserten Verhalten der Halbleiterchips in Sperr-Richtung führen.

In einer weiteren bevorzugten Ausgestaltung weist das Dotierprofil zumindest eine weitere Dotierspitze auf. Insbesondere kann zwischen der Dotierspitze und der weiteren Dotierspitze zumindest eine Quantenschicht der n-leitenden Mehrschichtstruktur angeordnet sein. Mit anderen Worten kann das Dotierprofil derart ausgebildet sein, dass ein Teil der Quantenschichten der n-leitenden Mehrschichtstruktur hoch n-dotiert ist, während der verbleibende Teil der Quantenschichten im Vergleich hierzu niedrig n-dotiert ist.

Das Dotierprofil kann auch mehr als zwei Dotierspitzen, insbesondere zwischen einschließlich eine und einschließlich fünf Dotierspitzen, vorzugsweise zwischen einschließlich eine und einschließlich drei Dotierspitzen aufweisen.

In einer bevorzugten Ausgestaltung des Halbleiterchips ist ein Aufwachssubstrat für die Halbleiterschichtenfolge des Halbleiterkörpers vollständig oder zumindest teilweise entfernt. Ein derartiger Halbleiterchip wird auch als Dünnfilm-Halbleiterchip bezeichnet.

Ein Dünnfilm-Halbleiterchip, etwa ein Dünnfilm-LeuchtdiodenChip, kann sich weiterhin im Rahmen der vorliegenden Erfindung durch mindestens eines der folgenden charakteristischen Merkmale auszeichnen:
- an einer zu einem Trägerelement hin gewandten ersten Hauptfläche eines Halbleiterkörpers, der eine Halbleiterschichtenfolge mit einem aktiven Bereich umfasst, insbesondere einer Epitaxieschichtenfolge, ist eine Spiegelschicht aufgebracht oder, etwa als Braggspiegel in der Halbleiterschichtenfolge integriert, ausgebildet, die zumindest einen Teil der in der Halbleiterschichtenfolge erzeugten Strahlung in diese zurückreflektiert;
- die Halbleiterschichtenfolge weist eine Dicke im Bereich von 20µm oder weniger, insbesondere im Bereich von 10 µm auf; und/oder
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, d.h. sie weist ein möglichst ergodisch stochastisches Streuverhalten auf.

Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben.

Die Druckschriften US 6 677 619 B1, WO 2009/072787 A2, WO 2009/045005 A2 und US 2006/081861 A1 beschreiben jeweils einen lichtemittierenden Halbleiterchip mit einem n-leitenden modulationsdotierten Übergitter.

Die Druckschrift US 2008/149918 A1 offenbart einen Leuchtdiodenchip mit zwei Dotierspitzen auf der n-Seite des aktiven Bereichs.

Die Druckschrift EP 2 523 228 A2 ist Stand der Technik gemäß Artikel 54(3) EPÜ und offenbart den Gegenstand des Anspruchs 1 ohne das Merkmal von Barriereschichten mit einer Dotierkonzentration von mindestens 1 * 10¹⁶ cm⁻³ und höchstens 1 * 10¹⁸ cm ⁻³.

Die vorliegende Erfindung ist in Anspruch 1 definiert. Weitere Merkmale, Ausgestaltungen und Zweckmäßigkeiten ergeben sich aus den abhängigen Ansprüchen und aus der folgenden Beschreibung der Ausführungsbeispiele in Verbindung mit den Figuren.

Es zeigen:
Figur 1A ein Ausführungsbeispiel für einen Halbleiterkörper mit einer Halbleiterschichtenfolge in schematischer Schnittansicht,
Figur 1B schematische Darstellungen der eines Leitungsbandkantenverlaufs E_{C} und eines Dotierprofils jeweils entlang einer Abscheiderichtung z für einen Ausschnitt eines Halbleiterkörpers gemäß einem zweiten Ausführungsbeispiel,
Figur 2 ein erstes Ausführungsbeispiel für einen Halbleiterchip in schematischer Schnittansicht,
Figur 3 ein zweites Ausführungsbeispiel für einen Halbleiterchip in schematischer Schnittansicht, und
Figur 4 ein Ergebnis einer Messung eines Stroms I als Funktion einer in Rückwärtsrichtung anliegenden Spannung U.

Gleiche, gleichartige oder gleich wirkende Elemente sind in den Figuren mit gleichen Bezugszeichen versehen.

Die Figuren sind jeweils schematische Darstellungen und daher nicht unbedingt maßstabsgetreu. Vielmehr können vergleichsweise kleine Elemente und insbesondere Schichtdicken zur Verdeutlichung übertrieben groß dargestellt sein.

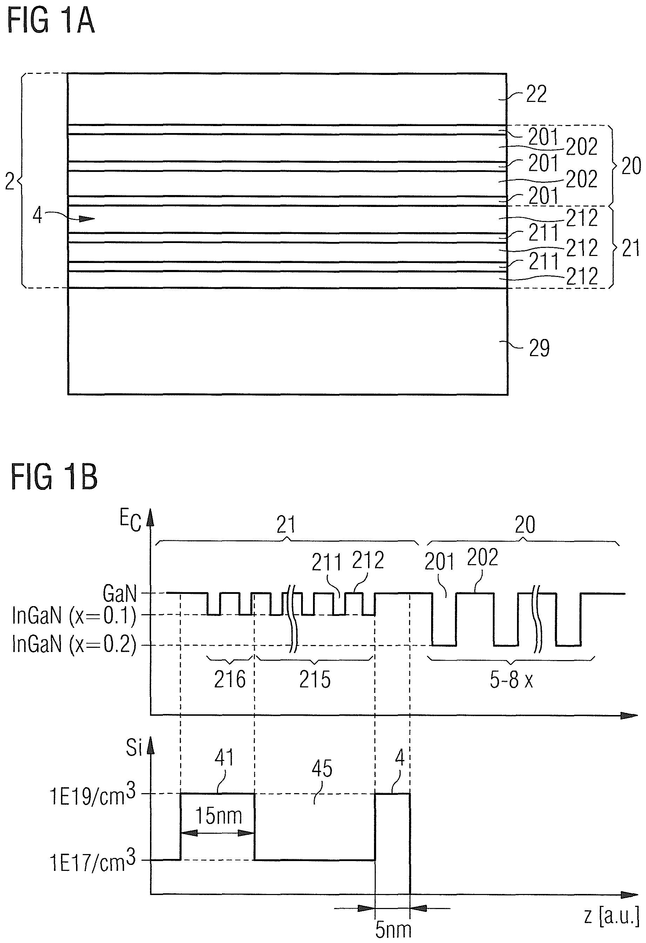

Ein erstes Ausführungsbeispiel für einen Halbleiterkörper für einen Halbleiterchip ist in Figur 1A schematisch in Schnittansicht dargestellt. Der Halbleiterkörper 2 weist eine Halbleiterschichtenfolge auf, welche den Halbleiterkörper bildet. Die Halbleiterschichtenfolge weist einen zur Erzeugung von Strahlung vorgesehenen aktiven Bereich 20 auf, der zwischen einer n-leitenden Mehrschichtstruktur 21 und einer p-leitenden Halbleiterschicht 22 angeordnet ist. Die Halbleiterschichtenfolge des Halbleiterkörpers ist vorzugsweise epitaktisch, insbesondere mittels MBE oder MOCVD, auf einem Aufwachssubstrat 29 abgeschieden. Bei einem Halbleiterkörper auf der Basis eines Nitrid-Verbindungshalbleiters eignet sich als Aufwachssubstrat beispielsweise Saphir, Siliziumkarbid, Silizium oder Galliumnitrid. Zwischen der n-leitenden Mehrschichtstruktur 21 und dem Aufwachssubstrat kann eine Pufferschicht ausgebildet sein, die insbesondere zur Steigerung der Kristallqualität vorgesehen sein kann (nicht explizit gezeigt).

Der aktive Bereich 20 weist eine Quantenstruktur auf, die durch eine Mehrzahl von Quantenschichten 201 und eine Mehrzahl von zwischen den Quantenschichten angeordneten Barriereschichten 202 gebildet ist. Der aktive Bereich weist hier lediglich exemplarisch eine Quantenstruktur mit drei Quantenschichten auf. Davon abweichend kann aber auch eine andere Anzahl von Quantenschichten, beispielsweise nur eine oder zwei Quantenschichten oder mehr als drei, etwa bis zu 20 Quantenschichten, beispielsweise fünf bis acht Quantenschichten, vorgesehen sein.

Die p-leitende Halbleiterschicht 22 kann auch mehrschichtig ausgebildet sein, wobei sich die einzelnen Schichten insbesondere durch die Materialzusammensetzung und/oder durch deren Dotierung voneinander unterscheiden können.

Die n-leitende Mehrschichtstruktur 21 weist eine Quantenstruktur mit einer Mehrzahl von Quantenschichten 211 auf, die zwischen Barriereschichten 212 angeordnet sind.

Eine Position einer Dotierspitze 4 in vertikaler Richtung, also in einer senkrecht zu einer Haupterstreckungsebene der Halbleiterschichten des Halbleiterkörpers 2, ist schematisch mittels eines Pfeils dargestellt. Die Dotierspitze befindet sich in der n-leitenden Mehrschichtstruktur 21, insbesondere zwischen der dem aktiven Bereich nächstgelegenen Quantenschicht 211 der n-leitenden Mehrschichtstruktur und der der n-leitenden Mehrschichtstruktur nächstgelegenen Quantenschicht 201 des aktiven Bereichs 20. In einem an die Dotierspitze 4 angrenzenden Bereich der n-leitenden Mehrschichtstruktur sind die Quantenschichten 211 und die an Quantenschichten angrenzenden Barriereschichten niedrig dotiert.

Mittels der Dotierspitze 4 kann eine effektive Injektion von Elektronen in den aktiven Bereich 20 erfolgen. In Rückwärtsrichtung bewirkt die Dotierspitze ebenfalls eine verbesserte Stromaufweitung, was zu einer verringerten Gefahr einer ESD-Schädigung des mittels der Halbleiterschichtenfolge gebildeten Halbleiterchips führt. Die verringerte ESD-Empfindlichkeit wird also bereits mit dem Abscheiden der Halbleiterschichtenfolge erzielt, so dass die Gefahr einer Schädigung in einem nachfolgenden Herstellungsschritt für den Halbleiterchip verringert ist.

Ein schematischer Verlauf einer Leitungsbandkantenverlaufs E_{C} sowie eines Silizium-Dotierprofils ist in Figur 1B als Funktion in z-Richtung für ein zweites Ausführungsbeispiel eines Halbleiterkörpers für einen Halbleiterchip dargestellt. Die z-Richtung entspricht der Abscheiderichtung der Halbleiterschichten des Halbleiterkörpers 2 und verläuft senkrecht zu einer Haupterstreckungsebene der Halbleiterschichten des Halbleiterkörpers 2.

Dieses zweite Ausführungsbeispiel entspricht im Wesentlichen dem im Zusammenhang mit Figur 1A beschriebenen ersten Ausführungsbeispiel für einen Halbleiterkörper. Im Unterschied hierzu ist in diesem Ausführungsbeispiel eine weitere Dotierspitze 41 ausgebildet.

Die weitere Dotierspitze 41 bildet einen hoch dotierten Teilbereich der Quantenstruktur der n-leitenden Mehrschichtstruktur 21. Zwischen der weiteren Dotierspitze und der Dotierspitze 4 ist ein niedrig n-leitend dotierter Bereich 45 der Quantenstruktur ausgebildet.

Der Halbleiterkörper 2, insbesondere der aktive Bereich 20, basiert in diesem Ausführungsbeispiel auf einem Nitrid-Verbindungshalbleitermaterial.

Der aktive Bereich 20 weist eine Mehrzahl von Quantenschichten 201 auf. In diesem Ausführungsbeispiel ist der aktive Bereich für die Erzeugung von Strahlung im blauen Spektralbereich vorgesehen. Hierfür weisen die Quantenschichten jeweils einen Indiumgehalt von x = 0,2 auf. Der aktive Bereich kann aber auch für die Emission von Strahlung in einem anderen Spektralbereich ausgebildet sein. Je höher der Indiumgehalt ist, desto niedriger ist die Bandlücke und damit die Energie der im aktiven Bereich erzeugbaren Photonen. Der Indiumgehalt kann also in weiten Grenzen variiert werden. Beispielsweise emittieren Quantenschichten mit einem Indium-Gehalt von x = 0,10 im Betrieb Strahlung im ultravioletten Spektralbereich und Quantenschichten mit einem Indium-Gehalt von x = 0,40 Strahlung im grünen Spektralbereich. Zwischen den Quantenschichten sind GaN-Barriereschichten 202 angeordnet.

Das Dotierprofil für die n-leitende Mehrschichtstruktur 21 ist in diesem Ausführungsbeispiel mittels einer Silizium-Dotierung realisiert. Es kann jedoch auch ein anderer Dotierstoff Anwendung finden.

Das Dotierprofil weist eine Dotierspitze 4 auf. Diese Dotierspitze beträgt in diesem Ausführungsbeispiel eine Breite von etwa 5 nm. Im Bereich der Dotierspitze 4 beträgt die Dotierkonzentration 1 * 10¹⁹ cm⁻³, während die Dotierkonzentration in einem an die Dotierspitze 4 angrenzenden niedrig n-leitend dotierten Bereich 45 eine Dotierkonzentration von 1 * 10¹⁷ cm⁻³ aufweist. Weiterhin weist das Dotierprofil eine weitere Dotierspitze 41 mit einer Breite von 15 nm auf, in dem die n-leitende Mehrschichtstruktur mit einer Dotierkonzentration von 1 * 10¹⁹ cm⁻³ n-leitend dotiert ist.

Mittels der Dotierspitzen kann eine in lateraler Richtung besonders gleichmäßige Ladungsträgerinjektion erzielt werden. Es erfolgt also eine effiziente Stromaufweitung, insbesondere unmittelbar unterhalb der Quantenschichten 201 des aktiven Bereichs.

Die n-leitende Mehrschichtstruktur 21 weist wie im Zusammenhang mit Figur 1A beschrieben eine Quantenstruktur mit einer Mehrzahl von Quantenschichten 211 auf, die jeweils zwischen Barriereschichten 212 angeordnet sind. Mittels des Dotierprofils entsteht ein niedrig dotierter Teilbereich 215 der Quantenstruktur und ein hoch dotierter Teilbereich 216 der Quantenstruktur. In diesen Bereichen können jeweils die Quantenschichten und/oder die Barriereschichten dotiert sein. Vorzugsweise sind zumindest im Bereich der zumindest einen Dotierspitze die Quantenschichten und die Barriereschichten hochdotiert ausgeführt.

Die n-leitende Mehrschichtstruktur 21 weist also sowohl einen niedrig dotierten Teilbereich der Quantenstruktur und als auch einen hoch dotierten Teilbereich der Quantenstruktur auf. Der niedrig dotierte Teilbereich 215 der Quantenschichten verläuft hierbei zwischen den Dotierspitzen 4,41 und bildet im Betrieb des Halbleiterchips ein Elektronenreservoir. In dem niedrig dotierten Teilbereich der Quantenstruktur sind die Quantenschichten 211 und die Barriereschichten 212 niedrig dotiert. Mittels der Dotierspitze 4 wird eine besonders effektive und in lateraler Richtung homogene Injektion von Ladungsträgern von der n-leitenden Mehrschichtstruktur 21 in die Quantenschichten des aktiven Bereichs 20 bewirkt.

Die Quantenschichten der n-leitenden Mehrschichtstruktur 21 weisen in diesem Ausführungsbeispiel exemplarisch einen Indium-Gehalt von x = 0,1 auf. Der Indium-Gehalt kann aber auch hiervon abweichend gewählt sein. Vorzugsweise ist der Indium-Gehalt höchstens so hoch wie der Indium-Gehalt der Quantenschichten im aktiven Bereich, sodass die Bandlücke der Quantenschichten der n-leitenden Mehrschichtstruktur 21 größer ist als die Bandlücke der Quantenschichten im aktiven Bereich 20 oder der Bandlücke der Quantenschichten im aktiven Bereich entspricht.

Die Quantenstruktur der n-leitenden Mehrschichtstruktur kann insbesondere als eine Quantentopfstruktur oder als ein Übergitter, beispielsweise mit Barriereschichten einer Dicke von weniger als 5 nm, etwa von etwa 2 nm, ausgeführt sein.

Eine effiziente Injektion von Ladungsträgern in den aktiven Bereich wird dadurch vereinfacht.

Selbstverständlich können die Materialzusammensetzungen des aktiven Bereichs 20 und der n-leitenden Mehrschichtstruktur 21 sowie das Dotierprofil auch von dem gezeigten Ausführungsbeispiel abweichen.

Vorzugsweise beträgt eine Dotierkonzentration in zumindest einer Dotierspitze 4 mindestens 4 * 10¹⁸ cm⁻³. Weiterhin bevorzugt beträgt die Dotierkonzentration in der Dotierspitze höchstens 1 * 10²⁰ cm⁻³, besonders bevorzugt höchstens 3 * 10¹⁹ cm⁻³.

In dem niedrig n-leitend dotierten Bereich 45 beträgt die Dotierkonzentration vorzugsweise höchstens 5 * 10¹⁷ cm⁻³, besonders bevorzugt höchstens 2 * 10¹⁷ cm⁻³.

Die Dotierkonzentration in der zumindest einen Dotierspitze ist vorzugsweise mindestens fünffach, besonders bevorzugt mindestens achtfach, so hoch wie in dem niedrig n-leitend dotierten Bereich der n-leitenden Mehrschichtstruktur.

Eine Dicke, also vertikale Ausdehnung, der Dotierspitze 4 und/oder der weiteren Dotierspitze 41 beträgt vorzugsweise zwischen einschließlich 1 nm und einschließlich 30 nm, besonders bevorzugt zwischen einschließlich 2 nm und einschließlich 20 nm, am meisten bevorzugt zwischen einschließlich 7 nm und einschließlich 10 nm.

Die Dotierspitze 4 weist vom aktiven Bereich 20 vorzugsweise einen geringen Abstand, besonders bevorzugt einen Abstand von höchstens 30 nm, auf, insbesondere zwischen einschließlich 1 nm und einschließlich 30 nm, bevorzugt zwischen einschließlich 2 nm und einschließlich 20 nm, am meisten bevorzugt zwischen einschließlich 7 nm und einschließlich 10 nm.

Weiterhin können von den gezeigten Ausführungsbeispielen abweichend auch mehr als zwei Dotierspitzen vorgesehen sein, beispielsweise zwischen einschließlich einer und einschließlich fünf Dotierspitzen.

Ferner kann die n-leitend dotierte Mehrschichtstruktur 21 von den gezeigten Ausführungsbeispielen abweichend auch Schichten oder Teilschichten aufweisen, die undotiert oder intrinsisch ausgeführt sind. In diesem Fall sind die undotierten oder intrinsisch ausgeführten Schichten zweckmäßigerweise so dünn, dass die n-leitende Mehrschichtstruktur 21 eine hinreichend hohe Leitfähigkeit für Elektronen in Abscheiderichtung aufweist.

Für die Herstellung eines möglichst rechteckförmigen Verlaufs des Dotierprofils im Bereich der Dotierspitzen 4, 41 erfolgt die Abscheidung vorzugsweise mit einer geringen Wachstumsrate, beispielsweise mit einer Rate zwischen einschließlich 20 nm/h und einschließlich 500 nm/h.

Weiterhin bevorzugt weist eine Kristallstruktur der n-leitenden Mehrschichtstruktur V-förmige Gruben auf, die sich insbesondere bei niedrigen Abscheidetemperaturen, etwa unterhalb von 950°C, vermehrt entlang von Versetzungen ausbilden. Diese V-förmigen Gruben können zu einem verbesserten Verhalten der Halbleiterchips bei Anliegen einer Spannung in Sperr-Richtung führen.

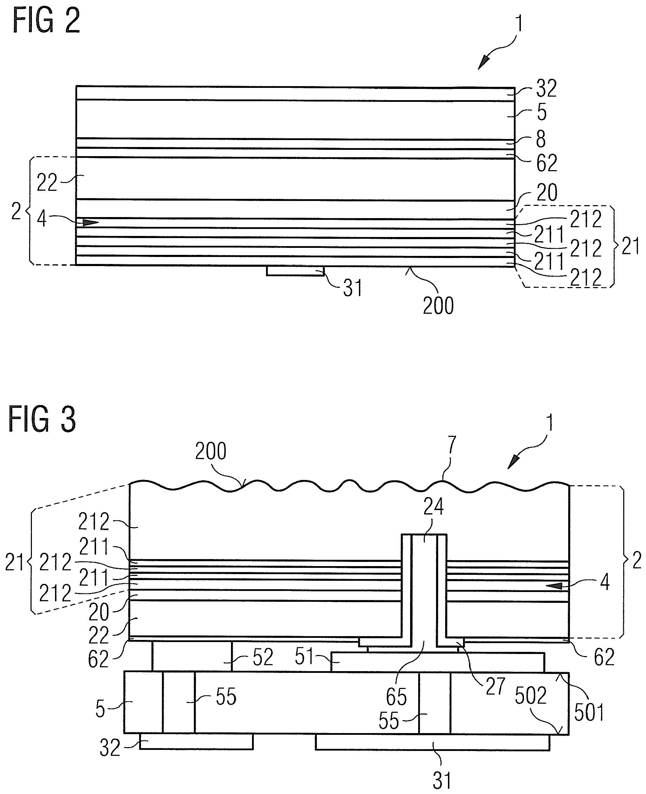

Ein erstes Ausführungsbeispiel für einen Halbleiterchip 1 ist in Figur 2 dargestellt, wobei der Halbleiterkörper 2 exemplarisch wie im Zusammenhang mit Figur 1A beschrieben ausgeführt ist.

Der Halbleiterchip 1 ist hierbei ein Dünnfilm-LED-Halbleiterchip ausgeführt, bei dem das Aufwachssubstrat 29 (Figur 1A) für die Halbleiterschichtenfolge des Halbleiterkörpers 2 entfernt ist. Der aktive Bereich 20 ist im Betrieb zur Erzeugung von inkohärenter Strahlung vorgesehen.

Der Halbleiterkörper 2 ist auf einem Träger 5 angeordnet. Der Träger 5 dient insbesondere der mechanischen Stabilisierung des Halbleiterkörpers, sodass das Aufwachssubstrat hierfür nicht erforderlich ist.

Als Trägermaterial eignet sich beispielsweise ein Halbleitermaterial, beispielsweise Silizium, Galliumarsenid oder Germanium, oder eine Keramik, etwa Aluminiumnitrid.

Der Träger 5 ist mittels einer Verbindungsschicht 8 mit dem Halbleiterkörper mechanisch stabil und weiterhin elektrisch leitend verbunden.

Beispielsweise eignet sich als Verbindungsschicht ein Lot oder ein elektrisch leitfähiger Klebstoff.

Zwischen dem Träger 5 und dem Halbleiterkörper 2 ist eine Spiegelschicht 62 ausgebildet. Mittels der Spiegelschicht kann im Betrieb des Halbleiterkörpers 2 im aktiven Bereich 20 erzeugte Strahlung, die in Richtung des Trägers 5 abgestrahlt wird, in Richtung der Strahlungsaustrittsfläche 200 reflektiert werden und somit aus dem Halbleiterchip austreten.

Auf der dem Träger 5 abgewandten Seite des Halbleiterkörpers 2 weist der Halbleiterkörper einen ersten Kontakt 31 auf. Auf der gegenüberliegenden Seite des Halbleiterchips, also auf der dem Halbleiterkörper 2 abgewandten Seite des Trägers 5, ist ein zweiter Kontakt 32 ausgebildet.

Der erste Kontakt und/oder der zweite Kontakt enthalten vorzugsweise ein Metall, beispielsweise Gold, Silber, Platin, Aluminium, Nickel, Chrom oder Kupfer oder eine Legierung mit zumindest einem der genannten Materialien.

Mittels des ersten Kontakts 31 und des zweiten Kontakts 32 können im Betrieb des Halbleiterchips 1 von verschiedenen Seiten Ladungsträger in den aktiven Bereich 20 injiziert werden und dort unter Emission von Strahlung rekombinieren.

Die über den ersten Kontakt 31 injizierten Elektronen werden in der n-leitenden Mehrschichtstruktur 21 im Bereich der zumindest einen Dotierspitze 4 effizient in lateraler Richtung verteilt und homogen in die Quantenschichten 201 des aktiven Bereichs 20 eingekoppelt.

Die Spiegelschicht 62 ist vorzugsweise metallisch ausgeführt und weist weiterhin bevorzugt eine hohe Reflektivität für die im aktiven Bereich erzeugte Strahlung auf. Beispielsweise eignet sich für die Spiegelschicht ein Metall, etwa Aluminium, Silber, Gold, Palladium oder Rhodium oder eine metallische Legierung mit zumindest einem der genannten Metalle.

Ein zweites Ausführungsbeispiel für einen Halbleiterchip 1 ist in Figur 3 schematisch in Schnittansicht dargestellt. Der Halbleiterkörper 2 ist hierbei wiederum wie im Zusammenhang mit Figur 1A beschrieben ausgeführt. Im Unterschied zum Halbleiterchip gemäß dem im Zusammenhang mit Figur 2 beschriebenen ersten Ausführungsbeispiel weist der Halbleiterkörper 2 eine Ausnehmung 24 auf, die sich von einer dem Träger 5 zugewandten Seite her durch die p-leitende Halbleiterschicht 22 und durch den aktiven Bereich 20 hindurch in die n-leitende Mehrschichtstruktur 21 hinein erstreckt. Die Ausnehmung durchdringt hierbei die Quantenschichten 211 der n-leitenden Mehrschichtstruktur. Die Seitenflächen der Ausnehmung sind von einer Isolationsschicht 27 bedeckt, die den Halbleiterkörper 2 vor einem elektrischen Kurzschluss des aktiven Bereichs 20 schützt.

In der Ausnehmung 24 ist eine Kontaktschicht 65 ausgebildet, die der elektrischen Kontaktierung des aktiven Bereichs von der der p-leitenden Halbleiterschicht 22 abgewandten Seite dient.

Der Träger 5 weist eine erste Anschlussfläche 51 und eine zweite Anschlussfläche 52 auf, wobei die erste Anschlussfläche 51 über die Kontaktschicht 65 mit der n-leitenden Mehrschichtstruktur 21 und die zweite Anschlussfläche 52 über die Spiegelschicht 62 mit der p-leitenden Halbleiterschicht 22 elektrisch leitend verbunden sind. Die erste Anschlussfläche 51 und die zweite Anschlussfläche 52 sind auf derselben Seite des Trägers 5 angeordnet.

Mittels der Ausnehmung 24 ist also die auf der dem Träger 5 abgewandten Seite des aktiven Bereichs 20 angeordnete n-leitende Mehrschichtstruktur 21 elektrisch kontaktierbar, sodass die Strahlungsaustrittsfläche 200 frei von einem externen elektrischen Kontakt ausgebildet sein kann. Eine Abschattung der Strahlungsaustrittsfläche durch einen nicht strahlungsdurchlässigen Kontakt wird dadurch vermieden.

Der Träger 5 weist Durchbrüche 55 auf, die sich von einer dem Halbleiterkörper 2 zugewandten ersten Hauptfläche 501 des Trägers bis zu einer der ersten Hauptfläche gegenüberliegenden zweiten Hauptfläche 502 hindurch erstrecken. Über diese Durchbrüche ist die erste Anschlussfläche 51 mit dem ersten Kontakt 31 und die zweite Anschlussfläche 52 mit dem zweiten Kontakt 32 elektrisch leitend verbunden, sodass der Halbleiterchip 1 von einer der Strahlungsaustrittsfläche 200 abgewandten Unterseite des Halbleiterchips her extern elektrisch kontaktierbar ist. Weiterhin weist der Halbleiterkörper 2 auf der Seite der Strahlungsaustrittsfläche 200 eine Strukturierung 7 auf. Die Strukturierung dient der Reduzierung von Totalreflexion von im aktiven Bereich erzeugter Strahlung innerhalb des Halbleiterchips und somit der Erhöhung der Auskoppeleffizienz. Selbstverständlich kann eine solche Strukturierung auch bei dem im Zusammenhang mit Figur 2 beschriebenen ersten Ausführungsbeispiel des Halbleiterchips vorgesehen sein.

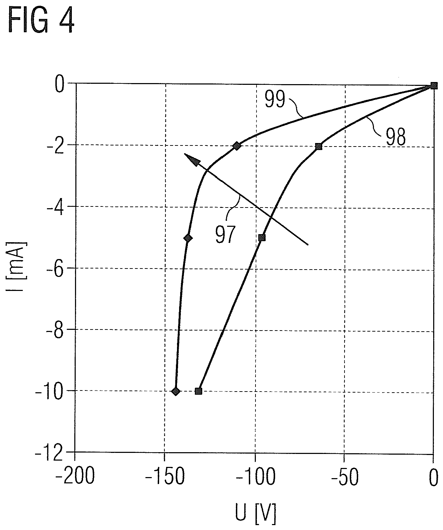

In Figur 4 ist das Verhalten des Rückwärtsstroms I als Funktion der Spannung in Rückwärtsrichtung, also in Sperr-Richtung des aktiven Bereichs 20, dargestellt. Eine Kurve 99 zeigt hierbei Messungen an einer Halbleiterschichtenfolge, aus der bei der nachfolgenden Prozessierung die Halbleiterkörper für die Halbleiterchips hervorgehen. Die Halbleiterschichtenfolge ist hierbei wie im Zusammenhang mit Figur 1B beschrieben ausgeführt.

Im Vergleich dazu zeigt eine Kurve 98 Messungen an einer Halbleiterschichtenfolge, bei dem ein herkömmlicher n-leitender Bereich ohne Dotierspitzen verwendet wird.

Ein Pfeil 97 veranschaulicht, dass mittels des beschriebenen Aufbaus der n-leitenden Mehrschichtstruktur 21 erzielt werden kann, dass der Stromverlauf für kleine Spannungen zunächst langsamer ansteigt und erst bei sehr hohen Spannungswerten einen steilen Anstieg des Stroms zeigt. Die Messkurve zeigt also einen erheblich stärker ausgeprägten knickartigen Verlauf.

Die Beschreibung der Ausführungsbeispiele erfolgte lediglich exemplarisch anhand der Beschreibung eines LED-Halbleiterchips. Die beschriebene Ausgestaltung der n-leitenden Mehrschichtstruktur 21 und des Dotierprofils mit zumindest einer Dotierspitze 4 kann aber auch für ein kohärente oder zumindest teilkohärente Strahlung emittierendes Bauelement Verwendung finden, beispielsweise für einen oberflächenemittierenden oder einen kantenemittierenden Halbleiterlaserchip beziehungsweise für eine RCLED (resonant cavity light emitting diode).

Die Erfindung ist nicht durch die Beschreibung anhand der Ausführungsbeispiele beschränkt.

## Patentansprüche

1. Halbleiterchip (1), der einen Halbleiterkörper (2) mit einer Halbleiterschichtenfolge aufweist, wobei
- die Halbleiterschichtenfolge eine n-leitende Mehrschichtstruktur (21), eine p-leitende Halbleiterschicht (22) und einen zur Erzeugung von Strahlung vorgesehenen aktiven Bereich (20), der zwischen der n-leitenden Mehrschichtstruktur und der p-leitenden Halbleiterschicht angeordnet ist, aufweist;
- in der n-leitenden Mehrschichtstruktur ein Dotierprofil ausgebildet ist, das zumindest eine Dotierspitze (4) aufweist, die verglichen mit zumindest einem daran angrenzenden Bereich eine hohe Dotierkonzentration von mindestens 2 * 10¹⁸ cm⁻³ aufweist;
- die n-leitende Mehrschichtstruktur (21) auf der dem aktiven Bereich (20) abgewandten Seite der Dotierspitze (4) eine Quantenstruktur mit einer Mehrzahl von Quantenschichten (211) aufweist, die zwischen Barriereschichten (212) angeordnet sind; und
- in einem an die Dotierspitze (4) angrenzenden Bereich der n-leitenden Mehrschichtstruktur die Quantenschichten (211) und die an die Quantenschichten angrenzenden Barriereschichten (212) mit einer Dotierkonzentration von mindestens 1 * 10¹⁶ cm⁻³ und höchstens 1 * 10¹⁸ cm⁻³ relativ niedrig dotiert sind.

2. Halbleiterchip nach Anspruch 1,
bei dem eine Dotierkonzentration in der zumindest einen Dotierspitze mindestens fünffach so hoch ist wie in einem niedrig n-leitend dotierten Bereich (45) der n-leitenden Mehrschichtstruktur.

3. Halbleiterchip nach Anspruch 2,
bei dem eine Dotierkonzentration in der zumindest einen Dotierspitze mindestens 4 * 10¹⁸ und in dem niedrig n-leitend dotierten Bereich höchstens 8 * 10¹⁷ cm⁻³ beträgt.

4. Halbleiterchip nach einem der Ansprüche 1 bis 3,
bei dem die Dotierspitze eine vertikale Ausdehnung zwischen einschließlich 1 nm und einschließlich 30 nm aufweist.

5. Halbleiterchip nach einem der Ansprüche 1 bis 4,
bei dem die Dotierspitze eine vertikale Ausdehnung zwischen einschließlich 5 nm und einschließlich 20 nm aufweist.

6. Halbleiterchip nach einem der Ansprüche 1 bis 5,
bei dem die Dotierspitze vom aktiven Bereich einen Abstand zwischen einschließlich 2 nm und einschließlich 20 nm aufweist.

7. Halbleiterchip nach einem der Ansprüche 1 bis 6,
bei dem der aktive Bereich eine Mehrzahl von Quantenschichten (201) aufweist, wobei die Dotierspitze zwischen der dem aktiven Bereich nächstgelegenen Quantenschicht der n-leitenden Mehrschichtstruktur und dem der n-leitenden Mehrschichtstruktur nächstgelegenen Quantenschicht des aktiven Bereichs angeordnet ist.

8. Halbleiterchip nach Anspruch 7,
wobei eine Bandlücke der Quantenschicht der n-leitenden Mehrschichtstruktur mindestens so groß ist wie eine Bandlücke der Quantenschicht (201) des aktiven Bereichs.

9. Halbleiterchip nach einem der Ansprüche 1 bis 8,
bei dem das Dotierprofil eine weitere Dotierspitze (41) aufweist, wobei zwischen der Dotierspitze und der weiteren Dotierspitze zumindest eine Quantenschicht der n-leitenden Mehrschichtstruktur angeordnet ist.

10. Halbleiterchip nach Anspruch 9,
bei dem ein Teilbereich (216) der Quantenstruktur der n-leitenden Mehrschichtstruktur mittels der weiteren Dotierspitze (45) eine hohe Dotierkonzentration aufweist.

11. Halbleiterchip nach einem der Ansprüche 1 bis 10,
bei dem der aktive Bereich auf einem nitridischen Verbindungshalbleitermaterial basiert.

12. Halbleiterchip nach einem der Ansprüche 1 bis 11,
bei dem eine Kristallstruktur der n-leitenden Mehrschichtstruktur V-förmige Gruben aufweist.

13. Halbleiterchip nach einem der Ansprüche 1 bis 12,
bei dem ein Aufwachssubstrat für die Halbleiterschichtenfolge des Halbleiterkörpers entfernt ist.

14. Halbleiterchip nach Anspruch 1,
bei dem
- eine Dotierkonzentration in der zumindest einen Dotierspitze mindestens fünffach so hoch ist wie in einem an die Dotierspitze angrenzenden Bereich der n-leitenden Mehrschichtstruktur;- der aktive Bereich eine Quantenstruktur mit mindestens einer Quantenschicht (201) aufweist; und
- eine Bandlücke der Quantenschicht der n-leitenden Mehrschichtstruktur größer ist als eine Bandlücke der Quantenschicht des aktiven Bereichs.

## Claims

1. A semiconductor chip (1) which has a semiconductor body (2) comprising a semiconductor layer sequence, wherein
- the semiconductor layer sequence comprises an n-conducting multilayer structure (21), a p-conducting semi-conductor layer (22) and an active region (20) for generating radiation, the active region (20) is arranged between the n-conducting multilayer structure and the p-conducting semiconductor layer;
- a doping profile is formed in the n-conducting multilayer structure, said doping profile comprising at least one doping tip (4) which has, compared to at least one region adjacent thereto, a high doping concentration of at least 2*10¹⁸ cm⁻³;
- the n-conducting multilayer structure (21) comprises a quantum structure having a plurality of quantum layers which are arranged between barrier layers (212); and
- in a region of the n-conducting multilayer structure adjoining the doping tip (4), the quantum layers (211) and the barrier layers (212) adjoining the quantum layers are lightly doped with a doping concentration of at least 1*10¹⁶ cm⁻³ and of at most 1*10¹⁸ cm⁻³.

2. The semiconductor chip according to claim 1,
in which a doping concentration in the at least one doping tip is at least five times as high as in a region of the n-conducting multilayer structure doped with low n-onductivity (45) .

3. The semiconductor chip according to claim 2,
in which a doping concentration in the at least one doping tip is at least 4*10¹⁸ cm⁻³ and in the low n-conductively doped region is at most 8*10¹⁷ cm⁻³.

4. The semiconductor chip according to one of claims 1 to 3, in which the doping tip has a vertical extent of between 1 nm and 30 nm inclusive.

5. The semiconductor chip according to one of claims 1 to 4, in which the doping tip has a vertical extent of between 5 nm and 20 nm inclusive.

6. The semiconductor chip according to one of claims 1 to 5, in which the doping tip has a distance of between 2 nm and 20 nm inclusive to the active region.

7. The semiconductor chip according to one of claims 1 to 6, in which the active region comprises a plurality of quantum layers (201), wherein the doping tip is arranged between the quantum layer of the n-conducting multi-layer structure closest to the active region and the quantum layer of the active region closest to the n-conducting multilayer structure.

8. The semiconductor chip according to claim 7,
wherein a band gap of the quantum layer of the n-conducting multilayer structure is at least as large as a band gap of the quantum layer (201) of the active region.

9. The semiconductor chip according to one of claims 1 to 8, in which the doping profile comprises a further doping tip (41), wherein at least one quantum layer of the n-conducting multilayer structure is arranged between the doping tip and the further doping tip.

10. The semiconductor chip according to claim 9,
in which a subregion (216) of the quantum structure of the n-conducting multilayer structure is formed by means of the further doping tip (45) has a high doping concentration.

11. The semiconductor chip according to one of claims 1 to 10,
in which the active region is based on a nitrid compound semiconductor material.

12. The semiconductor chip according to one of claims 1 to 11,
in which a crystal structure of the n-conducting multilayer structure has V-shaped pits.

13. The semiconductor chip according to one of claims 1 to 12,
in which a growth substrate for the semiconductor layer sequence of the semiconductor body is removed.

14. The semiconductor chip according to claim 1,
in which
- a doping concentration in the at least one doping tip is at least five times as high as in a region of the n-conducting multilayer structure adjoining the doping tip;
- the active region has a quantum structure with at least one quantum layer (201); and
- a band gap of the quantum layer of the n-conducting multilayer structure is larger than a band gap of the quantum layer of the active region.

## Revendications

1. Puce électronique à semiconducteur (1), qui présente un corps de semiconducteur (2) avec une succession de couches semiconductrices, sachant que
- la succession de couches semiconductrices présente une structure multicouches à conduction type n (21), une couche semiconductrice à conduction type p (22) et une zone active (20) prévue pour la production de rayonnement, qui est disposée entre la structure multicouches à conduction type n et la couche semiconductrice à conduction type p ;
- dans la structure multicouches à conduction type n, un profil de concentration du dopant est constitué, qui présente au moins une pointe de concentration du dopant (4), qui, comparée à au moins une zone adjacente à celle-ci, présente une concentration de dopant élevée d'au moins 2 * 10¹⁸ cm⁻³ ;
- la structure multicouches à conduction type n (21) présente, sur le côté de la pointe de concentration du dopant (4) détournée de la zone active (20), une structure quantique avec une pluralité de couches quantiques (211), qui sont disposées entre des couches barrières (212) ; et
- dans une zone adjacente à la pointe de concentration du dopant (4) de la structure multicouches à conduction type n, les couches quantiques (211) et les couches barrières adjacentes aux couches quantiques (212) sont dopées relativement faiblement avec une concentration de dopant d'au moins 1 * 10¹⁶ cm⁻³ et au plus 1 * 10¹⁸ cm³.

2. Puce électronique à semiconducteur selon la revendication 1,
pour laquelle une concentration de dopant est au moins cinq fois plus élevée dans au moins l'une des pointes de concentration du dopant que dans une zone faiblement dopée à conduction type n (45) de la structure multicouches à conduction type n.

3. Puce électronique à semiconducteur selon la revendication 2,
pour laquelle une concentration de dopant est d'au moins 4 * 10¹⁸ cm⁻³ dans au moins l'une des pointes de concentration du dopant et d'au plus 8 * 10¹⁷ cm⁻³ dans la zone faiblement dopée à conduction type n.

4. Puce électronique à semiconducteur selon une quelconque des revendications 1 à 3,
pour laquelle la pointe de concentration du dopant présente une extension verticale entre 1 nm inclus et 30 nm inclus.

5. Puce électronique à semiconducteur selon une quelconque des revendications 1 à 4,
pour laquelle la pointe de concentration du dopant présente une extension verticale entre 5 nm inclus et 20 nm inclus.

6. Puce électronique à semiconducteur selon une quelconque des revendications 1 à 5,
pour laquelle la pointe de concentration du dopant de la zone active présente un écart entre 2 nm inclus et 20 nm inclus.

7. Puce électronique à semiconducteur selon une quelconque des revendications 1 à 6,
pour laquelle la zone active présente une pluralité de couches quantiques (201), sachant que la pointe de concentration du dopant est disposée entre la couche quantique la plus proche de la zone active de la structure multicouches à conduction type n et la couche quantique la plus proche de la structure multicouches à conduction type n de la zone active.

8. Puce électronique à semiconducteur selon la revendication 7,
sachant qu'un écart magnétique de la couche quantique de la structure multicouches à conduction type n est au moins aussi grand qu'un écart magnétique de la couche quantique (201) de la zone active.

9. Puce électronique à semiconducteur selon une quelconque des revendications 1 à 8,
pour laquelle le profil de concentration du dopant présente une autre pointe de concentration du dopant (41), sachant qu'entre la pointe de concentration du dopant et l'autre pointe de concentration du dopant, au moins une couche quantique de la structure multicouches à conduction type n est disposée.

10. Puce électronique à semiconducteur selon la revendication 9,
pour laquelle une zone partielle (216) de la structure quantique de la structure multicouches à conduction type n présente une concentration de dopant élevée au moyen de l'autre pointe de concentration du dopant (45).

11. Puce électronique à semiconducteur selon une quelconque des revendications 1 à 10,
pour laquelle la zone active se base sur un matériau semiconducteur composite de nitrure.

12. Puce électronique à semiconducteur selon une quelconque des revendications 1 à 11,
pour laquelle une structure cristalline de la structure multicouches à conduction type n présente des fosses en forme de V.

13. Puce électronique à semiconducteur selon une quelconque des revendications 1 à 12,
pour laquelle un substrat épitaxique est supprimé pour la succession de couches semiconductrices du corps de semiconducteur.

14. Puce électronique à semiconducteur selon la revendication 1,
pour laquelle
- une concentration de dopant est au moins cinq fois plus élevée dans au moins l'une des pointes de concentration du dopant que dans une zone de la structure multicouches à conduction type n adjacente à la pointe de concentration du dopant ;
- la zone active présente une structure quantique avec au moins une couche quantique (201) ; et
- un écart magnétique de la couche quantique de la structure multicouches à conduction type n est plus grand qu'un écart magnétique de la couche quantique de la zone active.
